Europäisches Patentamt

European Patent Office

Office européen des brevets

(19)

(11) Veröffentlichungsnummer: **0 101 058**
**B1**

(12) **EUROPÄISCHE PATENTSCHRIFT**

(45) Veröffentlichungstag der Patentschrift :
05.04.89

(51) Int. Cl.⁴ : **H 05 K 13/00**

(21) Anmeldenummer : 83107875.3

(22) Anmeldetag : 09.08.83

(54) **Horde für Halb- und Fertigprodukte, insbesondere für elektrische Spulenkörper.**

(30) Priorität : 12.08.82 DE 3230075

(43) Veröffentlichungstag der Anmeldung :
22.02.84 Patentblatt 84/08

(45) Bekanntmachung des Hinweises auf die Patenterteilung : 05.04.89 Patentblatt 89/14

(84) Benannte Vertragsstaaten :
CH DE FR GB IT LI NL SE

(56) Entgegenhaltungen :
US--A-- 2 949 182
IBM TECHNICAL DISCLOSURE BULLETIN, Band 14, Nr. 3, August 1971, Seite 738, New York, US; F.W. EDMOND: "Container for chip carrier assemblies"
IBM TECHNICAL DISCLOSURE BULLETIN, Band 24, Nr. 7A, Dezember 1981, Seite 3298, New York, US; A. SAUNDERS: "Static-proof semiconductor carrier"

(73) Patentinhaber : Siemens Aktiengesellschaft Berlin und München
Wittelsbacherplatz 2
D-8000 München 2 (DE)

(72) Erfinder : Hofmann, Max
Veilchenweg 41
D-8028 Taufkirchen (DE)
Erfinder : Meindl, Gerhard, Dipl.-Ing.
Hartstrasse 22
D-8031 Alling (DE)

## Beschreibung

Die Erfindung betrifft eine Horde für elektrische Stiftspulenkörper für Spulen mit am einen Spulenkörperflansch befestigten Spulenkörperstiften, die in der Fertigung als Transporthorde für die Stiftspulenkörper und auch als Verpackungshorde für den Versand und die Lagerung bestimmter Fertigprodukte einsetzbar ist. Eine allgemein verwendbare Horde ist beispielsweise aus US-A-2 949 182 bekannt.

Bisher war es üblich, daß der Hersteller der elektrischen Stiftspulenkörper die Spulenkörper vorwiegend auf plattenförmige Schaumstoffe auf Kunststoffbasis, wie z. B. Polystyrol gesteckt, in Kartons verpackt und so an den Abnehmer, d. h. an den Hersteller elektrischer Spulen gesandt hat. Abnehmerseitig wurden dabei die Stiftspulenkörper manuell von den Schaumstoffträgern abgezogen und manuell oder mit Rund- oder Linearförderern auf die Spulenwickelmaschine gesteckt und nach ihrer Bewicklung und Lötung mittels je nach Spulenhersteller unterschiedlichsten Transporteinrichtungen und entsprechend angepaßten Ablagereinrichtungen zu den Montageeinrichtungen befördert. Die fertigmontierten elektrischen Spulen wurden schließlicht in eigens hierfür bestimmten Verpackungen an den Kunden verschickt.

Der vorliegenden Erfindung liegt die Aufgabe zugrunde, eine Horde zu schaffen, die für Halb- und Fertigprodukte und zwar insbesondere für den Transport elektrischer Stiftspulenkörper von Bearbeitungsmaschine zu Bearbeitungsmaschine und zusätzlich auch für die Verpackung der fertigbewickelten und gelöteten Spule geeignet ist. Diese als Transport- und Verpackungshorde verwendbare Horde soll darüberhinaus die Spulenkörper, nämlich vorwiegend Stiftspulenkörper mit angespitzten Anschlußstiften, vor Beschädigung schützen, und insbesondere Stiftverbiegungen, Stiftausbrüche und Brüche der Spulenkörperflansche, verursacht durch unsachgemäßen Transport, verhindern.

Zur Lösung dieser Aufgabe sieht die Erfindung bei einer Horde der eingangs genannten Art vor, daß diese als Profilschiene mit tunnelartigem Querschnitt ausgebildet ist, an deren Tunnelboden zueinander parallele und zu den Seitenwänden beabstandete stegförmige Auflager für die Spulenkörper angeformt sind, und daß beabstandet zum Tunnelboden Stege an die seitlichen Innenwände der Profilschiene angeformt sind, unter deren Wirkung die Spulenkörper gegen Verschieben in Richtung der Spulenkörperlängsachse gesichert sind.

Diese Horde ist als Verpackung für die unbewickelten Spulenkörper und für die fertigen Spulen gleichermaßen geeignet und ersetzt als Werkstückträger aufwendige und typengebundene Zuführungen und Maschineneinrichtungen. Die Horde ist, wie die Praxis gezeigt hat, bei entsprechender Gestaltung der Horde und der Zuführung zum Wickelautomaten ohne Zwischenschaltung mehrerer Elemente auf den Wickelautomaten aufsteckbar, so daß eine unmittelbare Entnahme der Spulenkörper erfolgen kann. Ein ansonsten dem Wickelautomaten vorangesetztes aufwendiges und nicht variables Zuführsystem für die Spulenkörper, wie z. B. ein Rund- oder Linearförderer entfällt dadurch. Die gleiche Horde kann die bereits gewickelten und gelöteten Spulenkörper wieder aufnehmen, d. h. die Horde kann auch als Werkstückträger zwischen der Wickel- und der ihr nachgeschalteten Spulen-Montagestraße dienen. Nach Beendigung der Spulenmontage können die fertigen Spulen gleichfalls in die gleichen Horden eingefügt und nach Verpackung in Kartons in den Versand gegeben werden.

Die Erfindung wird nachstehend anhand eines Ausführungsbeispiels näher erläutert. Es zeigt :

Fig. 1 eine Horde nach der Erfindung in schaubildlicher und perspektivischer Darstellung,

Fig. 2 eine Stirnansicht der Horde nach Fig. 1 samt fertigmontierter elektrischer Spule.

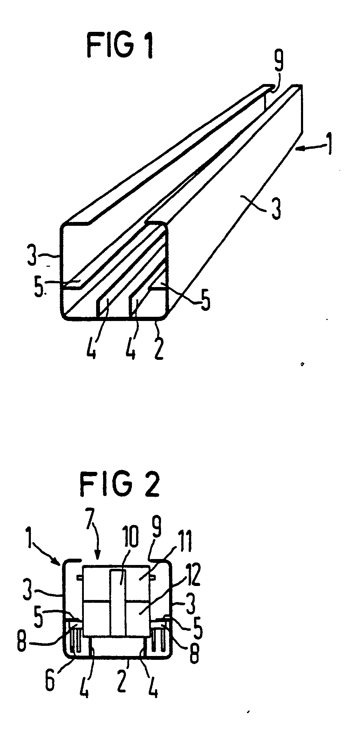

Die Horde nach Fig. 1 ist als Profilschiene 1 mit tunnelartigem Querschnitt ausgebildet. Am Tunnelboden 2 sind zueinander parallele und zu den Seitenwänden 3, 3 beabstandete stegförmige Auflager 4, 4 für die Spulenkörper bzw. für die fertigmontierten elektrischen Spulen 7 (siehe Fig. 2) angeformt. Die Auflager 4, 4 sind, was in der Zeichnung nicht dargestellt ist, durch einen Sockel ersetzbar, der beabstandet zu den Seitenwänden 3, 3 gleichfalls am Tunnelboden 2 angeformt ist. Im Abstand zum Tunnelboden 2 sind zusätzliche Stege 5, 5 vorzugsweise einstückig an die seitlichen Innenwände der Profilschiene 1 angeformt, unter deren Wirkung die Spulenkörper bzw. Spulen 7 gegen Verschieben in Richtung der Spulenkörperlängsachse gesichert sind.

Die Höhe der stegförmigen Auflager 4, 4 ist dabei so gewählt, daß die freien Enden der Spulenkörperstifte 6 in ausreichendem Abstand zum Tunnelboden 2 angeordnet sind, da andernfalls ein Verschieben der Spulenkörper bzw. Spulen in Hordenlängsrichtung nicht möglich ist. Die Höhe, in der die an die seitlichen Innenwände 3, 3 der Profilschiene 1 angeformten Stege 5, 5 über dem Tunnelboden 2 angeordnet sind, ist durch die Länge der Spulenkörperstifte 6 und durch die Dicke der Flansche 8 bestimmt. Diese Höhe ist üblich so gewählt, daß die Spulenkörper bzw. fertigmontierten Spulen gleichsam unter Klemmwirkung gegen die Auflager 4 gedrückt werden.

Die Fig. 2 zeigt in schematischer Darstellung eine in die Horde eingesetzte, fertigmontierte elektrische Spule 7, deren Schalenkernhälften 11, 12 durch eine insbesondere federnde Klammer 10 zusammengehalten sind. Die vom Tunnelboden 2 abgekehrte Seitenfläche der Profilschiene 1 kann geschlossen oder — wie dies in Fig. 1 und 2 gezeigt ist — mit einem Schlitz 9 ausgebildet sein, durch den eventuelle kennzeichnende Aufdrucke auf die Spulenoberseite ohne Entnahme der Spule aus der Horde lesbar sind.

Zur Sicherung der in die Horde eingefügten Spulenkörper und fertigen Spulen werden die Stirnenden der Profilschiene 1 z. B. mittels in der Zeichnung nicht dargestellter Klebbänder geschlossen.

## Patentansprüche

1. Horde für elektrische Stiftspulenkörper für Spulen mit an einem Spulenkörperflansch befestigten Spulenkörperstiften, die sowohl als Transporthorde für die Stiftspulenkörper als auch als Verpackungshorde für die fertige elektrische Spule einsetzbar ist, dadurch gekennzeichnet, daß die Horde als Profilschiene (1) mit tunnelartigem Querschnitt ausgebildet ist, an deren Tunnelboden (2) zueinander parallele und zu den Seitenwänden (3, 3) beabstandete stegförmige Auflager (4, 4) für die Spulenkörper angeformt sind, und daß beabstandet zum Tunnelboden Stege (5, 5) an die seitlichen Innenwände der Profilschiene angeformt sind, unter deren Wirkung die Spulenkörper gegen Verschieben in Richtung der Spulenkörperlängsachse gesichert sind.

2. Horde nach Anspruch 1, dadurch gekennzeichnet, daß die Höhe der stegförmigen Auflager (4, 4) so gewählt ist, daß die freien Enden der Spulenkörperstifte (6) im Abstand zum Tunnelboden (2) angeordnet sind.

3. Horde nach Anspruch 1, dadurch gekennzeichnet, daß die an die seitlichen Innenwände der Profilschiene (1) angeformten Stege (5, 5) in einer durch die Länge der Spulenkörperstifte (6) und die Flanschdicke bestimmten Höhe über dem Tunnelboden (2) angeordnet sind.

4. Horde nach Anspruch 1, dadurch gekennzeichnet, daß die Profilschiene (1) auf ihrer zum Tunnelboden (2) gegenüberliegenden Seitenfläche schlitzartig geöffnet ist.

5. Horde nach Anspruch 1, dadurch gekennzeichnet, daß die stegförmigen Auflager (4, 4) durch einen Sockel ersetzt sind, der beabstandet zu den Seitenwänden (3, 3) am Tunnelboden (2) angeformt ist.

## Claims

1. Container for electric pin coil bodies for coils having coil body pins fastened to a coil body flange, which is useful both as a transport container for the pin coil bodies and as a packing container for the finished electric coil, characterized in that the container is constructed as a profile rail (1) of tunnel-shaped cross-section, on the tunnel base (2) of which mutually parallel web-shaped supports (4, 4) are formed at an interval from the side walls (3, 3) for the coil bodies, and that at an interval from the tunnel base, webs (5, 5) are formed on the side inner walls of the profile rail, by the influence of which the coil bodies are secured against displacement in the direction of the longitudinal axis of the coil body.

2. Container according to Claim 1, characterized in that the height of the web-shaped supports (4, 4) is chosen so that the free ends of the coil body pins (6) are arranged at an interval from the tunnel base (2).

3. Container according to Claim 1, characterized in that the webs (5, 5) formed on the side inner walls of the profile rail (1) are arranged at a height above the tunnel base (2) determined by the length of the coil body pins (6) and the flange thickness.

4. Container according to Claim 1, characterized in that the profile rail (1) is opened in slit fashion on its side face opposite the tunnel base (2).

5. Container according to Claim 1, characterized in that the web-shaped supports (4, 4) are substituted by a pedestal which is shaped on the tunnel base (2) at an interval from the side walls (3, 3).

## Revendications

1. Récipient pour des corps de bobines électriques à broches pour des bobines comportant des broches fixées sur un flasque du corps de bobine, pouvant être utilisé aussi bien comme récipient de transport pour les corps de bobine à broches que comme récipient d'emballage pour la bobine électrique terminée, caractérisé par le fait que le récipient est réalisé sous la forme d'un rail profilé (1) possédant une section transversale en forme de tunnel, dans le fond (2) duquel sont formés par façonnage des supports (4, 4) en forme de barrettes parallèles entre elles et distantes des parois latérales (3, 3), pour les corps de bobines, et qu'à distance du fond du tunnel se trouvent formées par façonnage, sur les parois latérales intérieures du rail profilé, des barrettes (5, 5), sous l'action desquelles les corps de bobines sont bloqués contre tout déplacement dans la direction de leur axe longitudinal.

2. Récipient suivant la revendication 1, caractérisé par le fait que la hauteur des supports en forme de barrettes (4, 4) est choisie de telle sorte que les extrémités libres des broches (6) des corps de bobines sont distantes du fond (2) du tunnel.

3. Récipient selon la revendication 1, caractérisé par le fait que les barrettes (5, 5), formées par façonnage sur les parois intérieures latérales du rail profilé (1), sont disposées à une hauteur, déterminée par la longueur des broches (6) des corps de bobines et par l'épaisseur du flasque, au-dessus du fond (2) du tunnel.

4. Récipient selon la revendication 1, caractérisé par le fait que le rail profilé (1) est ouvert, à la manière d'une fente, sur sa surface latérale située à l'opposé du fond (2) du tunnel.

5. Récipient suivant la revendication 1, caractérisé par le fait que les supports en forme de barrettes (4, 4) sont remplacés par un socle, qui est formé par façonnage sur le fond (2) du tunnel, en étant distant des parois latérales (3, 3).

# FIG 1

# FIG 2